# EUROPÄISCHE PATENTSCHRIFT

(11) **EP 1 488 672 B1**
(45) Veröffentlichungstag und Bekanntmachung des Hinweises auf die Patenterteilung: **28.11.2007**
(21) Anmeldenummer: 03714520.8
(22) Anmeldetag: 24.03.2003
(51) Int. Cl.: H05K 7/20

(54) **ELEKTRONISCHES GER T**
ELECTRONIC DEVICE
APPAREIL ELECTRONIQUE

(30) Priorität: 25.03.2002 AT 4642002
(43) Veröffentlichungstag der Anmeldung: 22.12.2004
(73) Patentinhaber: Siemens AG Österreich, 1210 Wien (AT)
(72) Erfinder: PETRICEK, Martin, A-2020 Hollabrunn (AT); ROTHMAYER, Thomas, A-1180 Wien (AT)
(74) Vertreter: Peham, Alois
(86) Internationale Anmeldenummer: PCT/AT2003/000081
(87) Internationale Veröffentlichungsnummer: WO 2003/081970

(56) Entgegenhaltungen:
- WO-A-01/84898
- US-A- 4 621 304
- US-A- 5 991 155

## Beschreibung

Die Erfindung betrifft ein elektronisches Gerät mit einem Gehäuse, in welchem zumindest ein Schaltungsträger vorgesehen ist, wobei auf dem Schaltungsträger zumindest ein elektronischer Bauteil angeordnet ist, an der Innenseite einer der Seite des Schaltungsträgers, auf welcher der zumindest eine Bauteil angeordnet ist, gegenüberliegenden, im wesentlichen parallel zum Schaltungsträger verlaufenden Seitenwand des Gehäuses ein im wesentlichen plattenförmiges Kühlelement aus Metall angeordnet ist, welches in montiertem Zustand mit dem zumindest einem auf der Bestückungsseite angeordneten Bauteil thermisch verbunden ist.

Der Kühlung von Bauteilen, insbesondere von Halbleitebauteilen, die auf Schaltungsträgern angeordnet sind kommt eine wesentliche Bedeutung in Hinblick auf das ordnungsgemäße Funktionieren eines elektronischen Gerätes zu.

Eine bekannte Möglichkeit, um Halbleitebauteile vor einer Überhitzung zu schützen, besteht darin, die entstehende Verlustleistung auf mehrere Halbleiter aufzuteilen. Bei einer anderen häufig verwendeten Methode werden Kühlkörper auf dem Schaltungsträger montiert, die jedoch sehr viel Platz auf dem Schaltungsträger beanspruchen. Darüber hinaus werden bei der zuletzt genannten Methode auch zusätzliche Befestigungselemente benötigt, um die Halbleiterbauteile gegen die Kühlkörper zu pressen und somit thermisch zu kontaktieren.

Ein derartiges Kühlelement ist beispielsweise aus der US 5 991 155 A bekannt geworden. Dieses Dokument offenbart ein Kühlelement für ein elektronisches Gerät, welches einen U-förmigen Querschnitt aufweist, wobei von dem Kühlelement und einer Gehäuseseitenwand des Gerätes eine Kammer gebildet wird, die mit einer Wärmeleitpaste gefüllt ist

Die US 4 621 304 A zeigt ein plattenförmiges Kühlelement der eingangs genannten Art, welches mit Schrauben an einer Seitenwand eines elektronischen Gerätes verschraubt ist, wobei ein zu kühlendes Bauelement an den Schrauben anliegt und somit von dem Kühlelement beabstandet ist.

Nachteilig an den bekannten Lösungen ist, dass mit ihnen ein großer Platzverbrauch auf dem Schaltungsträger einhergeht und der Montage und Materialaufwand sehr hoch ist, wodurch sich auch hohe Produktionskosten ergeben können. Darüber hinaus ist es bei der zuletzt genannten Lösung weiters von Nachteil, dass sich bauartbedingt kein optimaler Wärmeübergang zwischen dem plattenförmigen Kühlelement und dem zu kühlenden Bauelement ergibt.

Es ist daher eine Aufgabe der Erfindung, ein elektronisches Gerät zu schaffen, mit welchem die oben genannten Nachteile der bekannten Geräte überwunden werden können.

Diese Aufgabe wird mit einem elektronischen Gerät der eingangs genannten Art erfindungsgemäß dadurch gelöst, dass die Seitenwand in einem montierten Zustand des Gerätes durch Befestigungsmittel an dem Schaltungsträger fixiert ist, wodurch das Kühlelement gegen den Rücken des zu kühlenden Bauteils gepresst ist.

Durch die thermische Verbindung mit einem an einer Gehäusewand angeordnetem Kühlelement kann die Wärme von Bauelementen, abtransportiert und über das Gehäuse an die Umgebung abgegeben werden, wobei das Kühlelement als Blech ausgeführt sein kann. Durch die erfindungsgemäße Lösung lässt sich die Herstellung von elektronischen Geräten wesentlich vereinfachen und kostengünstiger durchführen.

Um den Wärmeübergang zwischen einem Bauteil und dem Kühlelement zu verbessern, kann zwischen dem zumindest einem Bauteil und dem Kühlelement eine Wärmeleitfolie vorgesehen sein.

Vorteilhafterweise ist das Kühlelement an der Seitenwand befestigt, beispielsweise angenietet.

Günstige Kühleigenschaften werden erreicht, wenn das Kühlelement aus Kupfer oder aus einer Kupferlegierung oder aus Aluminium oder aus einer Aluminiumlegierung hergestellt ist.

Eine optimale Kühlung und eine sehr einfache Montage des Gerätes lassen sich dadurch gewährleisten, dass die Seitenwand in montiertem Zustand des Gerätes durch Befestigungsmittel an dem Schaltungsträger fixiert und das Kühlelement gegen den Rücken des zumindest einen Bauteils gepresst ist.

Die Erfindung samt weiteren Vorteilen ist im folgenden anhand eines nicht einschränkenden Ausführungsbeispiels näher erläutert, welches in der Zeichnung dargestellt ist. In dieser zeigen schematisch:
- Fig. 1: ein erfindungsgemäßes elektronisches Gerät, während der Montage in perspektivischer Ansicht;
- Fig. 2: das Gerät aus Fig. 1 während der Montage in einer anderen perspektivischen Ansicht;
- Fig. 3: eine Draufsicht auf das Gerät aus Fig. 1 in montiertem Zustand und
- Fig. 4: den Bereich A aus Fig. 3 im näheren Detail.

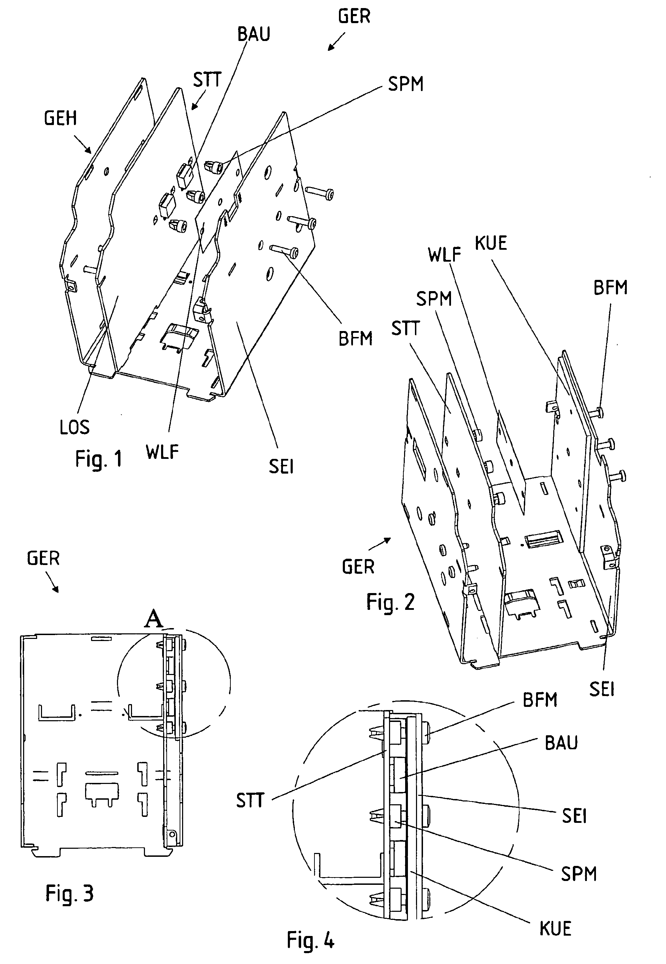

Gemäß Fig. 1 und 2 weist ein erfindungsgemäßes elektronisches Gerät GER ein Gehäuse GEH auf, in welchem ein Schaltungsträger STT mit einer Lötseite LOS angeordnet ist. Auf der Oberfläche der Lötseite LOS des Schaltungsträgers ist zumindest ein elektronischer Bauteil BAU angeordnet, wobei der Bauteil BAU bei einem automatischen Verlöten durch das Lötzinn fährt. Bei der hier dargestellten Oberflächenmontage sind Bestückungs- und Lötseite LOS identisch Die dafür erforderlichen Bauteile BAU, sogenannte "surface mounted devices" oder kurz SMD-Bauteile, weisen üblicherweise keine Anschlussdrähte auf. Sie werden mit ihren Anschlussflächen direkt auf einer Leiterbahn des Schaltungsträgers STT verlötet. Bohrungen in dem Schaltungsträger STT sind nur für Durchkontaktierungen und im Fall einer Mischbestückung erforderlich sowie zur Anbringung von Befestigungselementen notwendig.

Obwohl sich die hier dargestellte Ausführungsform der Erfindung auf SMD-Bauteile bezieht, ist die Erfindung keineswegs auf die Verwendung von SMD-Bauteile BAU beschränkt. Die erfindungsgemäße Lösung kann auch für Bauteile BAU Verwendung finden, welche auf einem Schaltungsträger STT mit einer Bestückungsseite und einer Lötseite angeordnet sind, die einander gegenüberliegen.

Erfindungsgemäß ist an der Innenseite einer der Seite des Schaltungsträgers STT, auf welcher die Bauteile BAU angeordnet sind, gegenüberliegenden, im wesentlichen parallel zum Schaltungsträger STT verlaufenden Seitenwand SEI des Gehäuses GEH ein im wesentlichen plattenförmiges Kühlelement KUE aus Metall, beispielsweise aus Aluminium oder einer Kupferlegierung, angeordnet. Das Kühlelement KUE ist in montiertem Zustand mit den auf der Lötseite LOS angeordneten Bauteilen BAU thermisch verbunden.

Bevorzugterweise ist das Kühlelement KUE aus einem Blechstück gefertigt und an der Seitenwand SEI befestigt, beispielsweise sind das Kühlelement KUE und die Seitenwand SEI miteinander vernietet. Die Seitenwand SEI ist in montiertem Zustand des Gerätes GER durch Befestigungsmittel BFM an dem Schaltungsträger STT fixiert, wobei das Kühlelement KUE gegen die Rücken der Bauteile BAU gepresst ist, sodass eine gute thermische Verbindung zwischen den Bauteilen BAU und dem Kühlelement KUE gewährleistet ist

Da das Kühlelement KUE mit der Seitenwand SEI in thermischen Kontakt steht, kann die von den Bauteilen BAU auf das Kühlelement KUE übertragene thermische Energie über die Seitenwand SEI an die Umgebung abgegeben werden kann. Aufgrund der Eigenkonvektion des Kühlelementes KUE und der Seitenwand SEI kann eine gute Kühlleistung erzielt und auf zusätzliche Kühlvorrichtungen in dem Gehäuse GEH, wie beispielsweise Gebläse, etc., verzichtet werden.

Um die Seitenwand SEI mit dem Schaltungsträger STT zu verbinden, können in den Schaltungsträger STT Spreizmuttern SPM aus Kunststoff eingepresst sein, wobei durch Öffnungen in der Seitenwand SEI die Befestigungsmittel BMF z. B. Schrauben, vorzugsweise Schrauben mit Gewinde für Kunststoffe, in die Spreizmuttern SPM einführbar sind. Auf diese Weise kann durch Verschrauben dieser speziellen Schrauben mit den Spreizmuttern SPM die Seitenwand SEI des Gehäuses GEH gegen den Schaltungsträger STT fixiert und das Kühlelement KUE in montiertem Zustand gegen die Bauteile gepresst werden (Fig. 3 und 4). In diesem Fall übernimmt der Schaltungsträger STT die Funktion eines Anpressbügels für das Kühlelement KUE.

Die Wärmeübertragung von den Bauteilen BAU auf das Kühlelement KUE kann durch Anordnung einer Wärmeleitfolie WLF zwischen den Bauteilen und dem Kühlelement KUE verbessert werden.

Durch die an dem Gehäuse GEH angeordneten Kühlelemente KUE kann zum einen die Anzahl der benötigten Bauelemente BAU auf ein Minimum optimiert werden und zum anderen lässt sich die Montage zusätzlicher Kühler auf dem Schaltungsträger vermeiden.

## Patentansprüche

1. Elektronisches Gerät (GER) mit einem Gehäuse (GEH), in welchem zumindest ein Schaltungsträger (STT) vorgesehen ist, wobei auf dem Schaltungsträger (STT) zumindest ein elektronischer Bauteil (BAU) angeordnet ist, an der Innenseite einer der Seite (LOS) des Schaltungsträgers (STT), auf welcher der zumindest eine Bauteil (BAU) angeordnet ist, gegenüberliegenden, im wesentlichen parallel zum Schaltungsträger (STT) verlaufenden Seitenwand (SEI) des Gehäuses (GEH) ein im wesentlichen plattenförmiges Kühlelement (KUE) aus Metall angeordnet ist, welches in montiertem Zustand an der Seitenwand anliegt und mit dem zumindest einem auf der Bestückungsseite (BES) angeordneten Bauteil (BAU) thermisch verbunden ist, **dadurch gekennzeichnet, dass** die Seitenwand (SEI) in einem montierten Zustand des Gerätes (GER) durch Befestigungsmittel (BFM) an dem Schaltungsträger (STT) fixiert ist, wodurch das Kühlelement (KUE) gegen den Rücken des zu kühlenden Bauteils (BAU) gepresst ist.

2. Elektronisches Gerät nach Anspruch 1, **dadurch gekennzeichnet, dass** zwischen dem zumindest einem Bauteil (BAU) und dem Kühlelement (KUE) eine Wärmeleitfolie (WLF) vorgesehen ist.

3. Elektronisches Gerät nach Anspruch 1 oder 2, **dadurch gekennzeichnet, dass** das Kühlelement (KUE) an der Seitenwand (SEI) befestigt, beispielsweise angenietet ist.

4. Elektronisches Gerät nach einem der Ansprüche 1 bis 3, **dadurch gekennzeichnet, dass** das Kühlelement (KUE) aus Kupfer oder aus einer Kupferlegierung oder aus Aluminium oder aus einer Aluminiumlegierung hergestellt ist.

## Claims

1. Electronic device (GER) with a housing (GEH), in which at least one circuit carrier (STT) is provided, with at least one electronic component (BAU) being arranged on the circuit carrier (STT), an essentially plate-shaped cooling element (KUE) made of metal being arranged on the inside of a side wall (SEI) of the housing (GEH) which runs essentially parallel to the circuit carrier (STT) and lies opposite to one of the sides (LOS) of the circuit carrier (STT), on which the at least one component (BAU) is arranged, said cooling element being present in an assembled state on the side wall and being thermally connected to the at least one component (BAU) arranged on the component side (BES), **characterised in that** in an assembled state of the device (GER), the side wall (SEI) is fastened to the circuit carrier (STT) by means of the fastening means (BFM), as a result of which the cooling element (KUE) is pressed against the rear of the component (BAU) to be cooled.

2. Electronic device according to claim 1, **characterised in that** a heat conducting foil (WLF) is provided between the at least one component (BAU) and the cooling element (KUE).

3. Electronic device according to claim 1 or 2, **characterised in that** the cooling element (KUE) is fastened to the side wall (SEI), is screwed thereto for instance.

4. Electronic device according to one of claims 1 to 3, **characterised in that** the cooling element (KUE) is produced from copper of a copper alloy or from aluminium or an aluminium alloy.

## Revendications

1. Appareil (GER) électronique comprenant un boîtier (GEH), dans lequel est prévu au moins un porte-circuit (STT), au moins un composant (BAU) électronique étant monté sur le porte-circuit (STT), un élément (KUE) de refroidissement en métal, sensiblement en forme de plaque, étant disposé sur la paroi (SEI) latérale du boîtier (GEH) opposé aux côtés inférieurs de l'une des faces (LOS) du porte-circuit (STT) sur lequel est monté le au moins composant (BAU) et s'étendant sensiblement parallèlement au porte-circuit (STT), élément de refroidissement qui à l'état monté s'applique à la paroi latérale et est relié à le au moins un composant (BAU) disposé sur le côté (BES) d'implantation, **caractérisé en ce que** la paroi (SEI)latérale est immobilisée, lorsque l'appareil (GER) est monté sur le porte-circuit (STT), par des moyens (BFM) de fixation, l'élément (KUE) de refroidissement étant repoussé contre le dos du composant (BAU) à refroidir.

2. Appareil électronique suivant la revendication 1,
**caractérisé en ce qu'**il est prévu une feuille (WLF) conductrice de la chaleur entre le au moins un composant (BAU) et l'élément (KUE) de refroidissement.

3. Appareil électronique suivant la revendication 1 ou 2,
**caractérisé en ce que** l'élément (KUE) de refroidissement est fixé à la paroi (SEI) latérale en y étant par exemple rivée.

4. Appareil électronique suivant l'une des revendications 1 à 3, **caractérisé en ce que** l'élément (KUE) de refroidissement est en cuivre ou en un alliage de cuivre ou en aluminium ou en un alliage d'aluminium.
